## Europäisches Patentamt
## European Patent Office
## Office européen des brevets

(11) Publication number: **0 121 000 B1**

(12) **EUROPEAN PATENT SPECIFICATION**

(45) Date of publication of patent specification: 25.03.87

(51) Int. Cl.⁴: **H 01 R 13/193**, H 01 R 23/68

(21) Application number: 83112887.1

(22) Date of filing: 21.12.83

(54) Circuit board and connector.

(30) Priority: 03.03.83 US 471955
29.06.83 US 509003

(43) Date of publication of application:
10.10.84 Bulletin 84/41

(45) Publication of the grant of the patent:
25.03.87 Bulletin 87/13

(84) Designated Contracting States:
DE FR GB

(56) References cited:
EP-A-0 018 422
US-A-3 518 612
US-A-3 793 609
US-A-4 068 170
US-A-4 159 154

(73) Proprietor: International Business Machines
Corporation
Old Orchard Road
Armonk, N.Y. 10504 (US)

(72) Inventor: Boland, Lawrence Joseph
42, Colburn Drive
Poughkeepsie New York 12603 (US)
Inventor: Gillett, John Brian
Riverview Terrace
Kingston New York 12401 (US)

(74) Representative: Grant, Iain Murray
IBM United Kingdom Limited Intellectual
Property Department Hursley Park
Winchester Hampshire SO21 2JN (GB)

Courier Press, Leamington Spa, England.

## Description

The present invention relates to zero insertion force (ZIF) type printed circuit board edge connectors and contacts.

It is well known in the art that substantial force is required to insert a printed circuit board into an other-than-ZIF mating edge connector due to the wiping engagement between the electrical contact pads on the board and the contact regions of the pins or springs in the mating connector. As the number of contacts increases, the force required to effect insertion also increases and will eventually reach a point where the force required will be excessive for practical use. Also, repeated insertion and extraction of a board into and from a corresponding mating connector will cause repeated wipings to occur between the contact pads and the contact springs and may result in excessive wear to the contact pads.

A common solution to this problem is the zero insertion force (ZIF) type connector, see for example US—A—4,068,170. In these connectors, the contact pins located in the connector are movable between two positions. In the first position, the pins are retracted from the board insertion path thereby allowing the unobstructed and low force insertion of the printed circuit board into the connector. In the second position, the contact pins are moved by an actuator into engaging contact with the contact pads of the board.

When designing a zero insertion force connector and counterpart board pair for dense contact packing, mechanical tolerances of the printed circuit board and of the mating connector must be considered. These mechanical tolerances stem from unavoidable manufacturing deviations from piece to piece and from lot to lot as well as variations in mechanical dimensions due to environmental operating conditions. A prudent design of a zero insertion force connector intended for large volume production will ensure that every printed circuit board can mate with every connector under a worst-case accumulation of mechanical tolerance. Further, previous connectors have oppositely aligned contact pins which, under a worst-case design will cause the contact pins of a dimensionally nominal connector to touch the opposite facing pins when the pins are actuated in the absence of a printed circuit board in the connector. This invention, which modifies both boards and connectors, avoids such problems.

In a modular or expandable system using a plurality of zero insertion force connectors, often several of the connectors are vacant, i.e. without printed circuit boards. Aesthetics or other constraints often require these vacant connectors to be in the actuated or closed state. If the opposite facing contact pins of the vacant and closed connectors touch each other thereby producing electrical short circuits, damage to the remaining electrical circuitry may result or erroneous signals may be generated.

It is therefore desirable to provide a zero insertion force type electrical connection arrangement that will permit denser contact packing and yet will not cause opposite facing contact pins to contact and short circuit when the pins are actuated in the absence of a printed circuit board within the connector. This arrangement must also maintain a conservative worst-case design philosophy to ensure compatibility between any board/connector combination that is intended to be compatible.

The invention as herein described and claimed will resolve the drawbacks of the prior art. The invention involved redesign of the board and of the socket. It solves the problem of providing a zero insertion force printed circuit board edge connector that will ensure electrical connection under a worst-case accumulation of mechanical tolerances while precluding the short circuiting of connector contact pins when the connector is actuated in the absence of a board within the connector. The invention includes a unique contact pad pattern for the edge of the mating printed circuit board, and a unique connector contact pin configuration.

For best results, a unique pattern of contact pads is disposed along inserted edge of the printed circuit board. The rows of contact pads are offset and slightly interleaved in order to reduce the board area required for electrical connections while maintaining a high probability of contact. Denser packing can be obtained by using elliptical contact pads.

Self-biased, spring-like contact pins in the connector are formed so that the contact regions of the contact pins lie in at least two horizontal planes. The longer pins located on one side of the connector are located opposite the shorter pins on the other side of the connector. When the connector is actuated in the absence of a printed circuit board, the short pins will move under the opposing long pins but the pins will not contact or short circuit. During actuation, contact regions of the pins will move more than half way across the connector opening, thereby guaranteeing wiping contact with and electrical connection to any card regardless of dimensional tolerance or of card position within the connector opening.

The present invention provides a circuit board adapted to mate with a zero insertion force type electrical connector and having two rows of connector contact pins on each side thereof, the circuit board having, for each connector contact pin to which electrical connection is required to be made, a corresponding contact pad, the contact pads forming, in general, two staggered rows on each side of the edge of the circuit board, the contact pads each having a narrowing aspect facing adjacent contact pads such that each contact pad encloses an elliptical area of high probability of pin contact and such that the contact pads of the rows on each side of the circuit board partially nest between the contact pads of the other row, while remaining electrically insulated from such pads and from each other.

The present invention also provides a complementary connector comprising a housing of electrically insulating material having a base and two side walls together defining an elongated opening opposite the base of the housing for receiving therein the insertion edge of the electrical circuit board and actuator displaceable contact pins mounted in the housing, forming, in the potential contact area, two rows of contact regions on each side of the housing, adapted to overlie the contact pads rows on the board so that, in general, on one side of the board, a long pin lies between a pair of short pins, and, where there is opposition, a long pin opposes a short pin, the pins being arranged, within mechanical tolerances and in the absence of the board and with the actuator operative, to cross the medial plane parallel to the side walls but only so far that each the contact region is precluded from touching any other contact region when the contact regions are moved through the medial plane by the actuator.

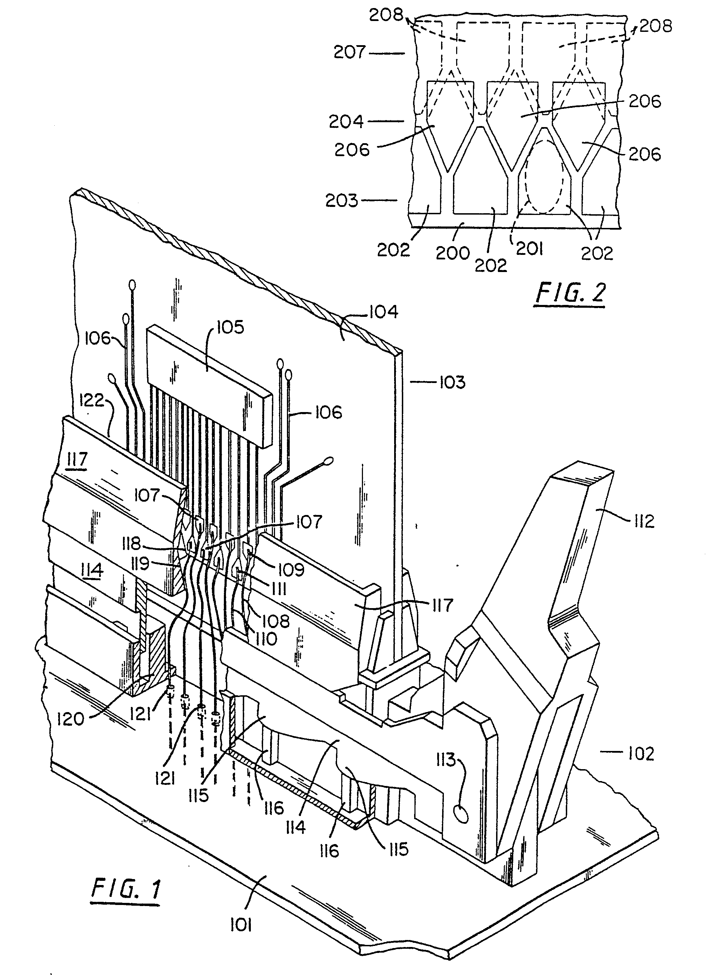

The present invention will be described further by way of example with reference to preferred embodiments of the invention, as illustrated in the accompanying drawing, in which Figure 1 is a diagram of one form of ZIF type connector embodying the present invention, in partial cross section showing a row of electrical contact pins and a printed circuit board with a two row contact pad pattern;

Fig. 2 is a detail diagram of another embodiment showing a two row electrical contact pad pattern and a three row electrical contact pad pattern disposed on the edge of a printed circuit board;

Fig. 3, in two orthogonal cross-sectional segments A and B, illustrates the actuation sequence of a pair of opposing contact pins with certain other pins removed for clarity; and

Fig. 4 shows a ZIF type connector in partial cross section showing a row of electrical contact pins and a printed circuit board with a three row electrical contact pad pattern.

Referring to Fig. 1, mother board 101 has mounted thereon a connector 102 of the zero insertion force (ZIF) type. Connector 102 is shown in partial cross-section to better illustrate the internal actuator mechanism. ZIF connector 102 is used to make electrical contact between printed circuit board unit 103 and mother board 101. Printed circuit board unit 103 includes a printed circuit board 104 with electrical components 105 mounted thereon. Although only one electrical component 105 is shown in Fig. 1, it will be understood that more than one component 105 can be mounted on printed circuit board 104. Circuit traces 106 are used to electrically connect components 105 with each other and with electrical contact pads 107 disposed in rows along the edge of printed circuit board 104.

Electrical contact pads 107 are shown in Fig. 1 arranged in two rows near the edge of printed circuit board 104. Long electrical contact pins 108 have contact regions 109 for contacting pads 107 located in the row farthest from the edge of printed circuit board 104. Short electrical contact pins 100 have contact regions 111 for contacting pads 107 located in the row nearest to the edge of printed circuit board 104.

Actuating handle 112 of connector 102 pivots about hinge pin 113 and moves linear cam 114 longitudinally of connector 102. When handle 112 pivots in a counterclockwise direction, linear cam 114 moves to the right parallel to the longitudinal dimension of connector 102. When handle 112 pivots in a clockwise direction, linear cam 114 moves to the left.

Linear cam 114 includes cam lobes 115 which ride on cam followers 116 during the motion of linear cam 114. The interaction between cam followers 116 and cam lobes 115 during the motion of linear cam 114 causes linear cam 114 to move perpendicular with the surface of mother board 101 thereby moving housing 117 in the same direction.

Housing 117 is made of an electrically insulating material and is formed with an elongated opening 122 at the top thereof. Printed circuit board unit 103 is received into housing 117 through elongated opening 122 along a board insertion path. The board insertion path can be generally described as a vertical plane passing through elongated opening 122 and oriented substantially parallel with the longitudinal dimension of elongated opening 122.

Housing 117 contains upper inclined surfaces 118 that cooperate with long contact pins 108 and lower inclined surfaces 119 that cooperate with short contact pins 110. As housing 117 is urged by linear cam 114 to move away from mother board 101, inclined surfaces 118 and 119 move electrical contact pins 108 and 110, respectively, toward electrical contact pads 107 located on printed circuit board 104. Electrical contact pins 108 and 110 are self-biased to assume a normal position retracted from printed circuit board 104 and as housing 117 moves toward mother board 101, electrical contact pins 108 and 110 move away from printed circuit board 104. In this manner, electrical contact pins 108 and 110 will move into and out of contact with pads 107 as handle 112 is pivoted.

Electrical contact pins 108 and 110 extend through base portion 120 of ZIF connector 102 and through vias 121 in mother board 101. Vias 121 will typically be connected to circuit traces (not shown) disposed on the surface of mother board 101. These traces will serve to make electrical connections between pins 108 and 110 and electronic circuitry located elsewhere on mother board 101.

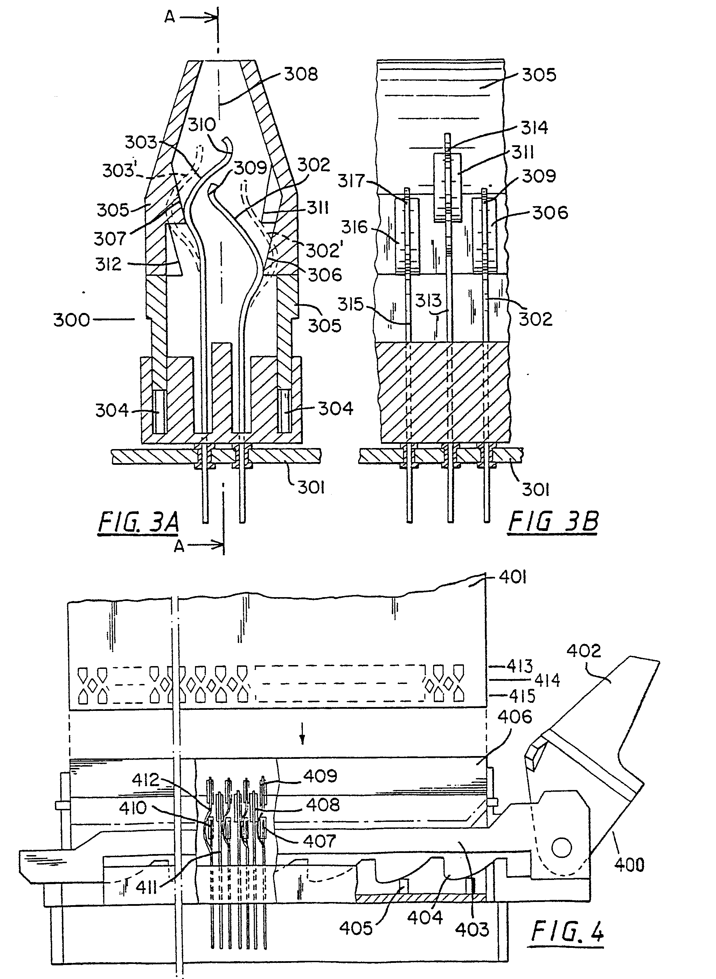

Another row of contact pins within housing 117, similar to pins 108 and 110, is located on the hidden side of printed circuit board unit 103 in Fig. 1. This other row is also moved into and out of contact with electrical contact pads located along the edge of the hidden surface of printed circuit board 104 as handle 112 is pivoted. The configuration of opposing pin rows will be detailed in Fig. 3.

Here it should be noted that the particular actuator mechanism in ZIF connector 102, used to urge pins 108 and 110 toward printed circuit board 104, herein described and illustrated in Fig. 1, is but one of several possible mechanisms that are well known to one skilled in the art. The presentation of this particular actuation mechanism is for illustrative purposes only and should not be construed to limit the scope of the claimed invention.

Fig. 2 illustrates an offset and interleaved electrical contact pad pattern disposed along the edge of a printed circuit board 200 according to this invention.

The pad pattern is based on the understanding that the ideal target area for a contact pin to touch and wipe a contact pad is an elliptical area 201. This elliptical area 201 is derived by statistical mechanical tolerance analysis techniques well known to a one skilled in the art.

Fig. 1 will be used to illustrate the application of the statistical mechanical tolerance analysis techniques to a connector/board combination.

For manufacturing purposes pins 108 and 110 have a specified nominal vertical length. In order to facilitate the manufacture of connector 102 and mating printed circuit board unit 103, this nominal vertical length has an acceptable positive and negative deviation which is typically called tolerance.

The tolerance is usually indicated for each length or other specified quantity on a mechanical drawing used in the manufacture and mechanical specification of connector 102 or board unit 103. Tolerances are associated with both horizontal and vertical dimensions.

Contact regions 109 and 110, associated with contact pins 108 and 110, respectively, also have a specified nominal vertical position with acceptable mechanical tolerances. At the same time, contact regions 109 and 111 have a nominal horizontal position with a horizontal tolerance. In a like manner, contact pads 107 on the surface of printed circuit board 104 have specified nominal locations with acceptable vertical and horizontal tolerances. Also, the dimensions of printed circuit board 104 have horizontal and vertical tolerances as does the mating position of printed circuit board 104 within connector 102.

The aforementioned dimensions associated with pins 108 and 110, board 104, and pads 107 combine to determine the point of contact between contact regions 109 and 110 and contact pads 107 on the surface of board 104.

If all of the mechanical dimensions are set to their nominal values, contact regions 109 and 111 will each contact the surface of printed circuit board 104 at one single point. Referring to Fig. 2, this single point is the centre of elliptical area 201.

If only the aforementioned vertical tolerances are considered, contact regions 109 and 111 will again each contact the surface of board 104 at a single point, but this single point will be located along a vertical line on the surface of printed circuit board 104. Referring to Fig. 2, this vertical line is the major axis of elliptical area 201.

If only the aforementioned horizontal tolerances are considered, contact regions 109 and 111 will each contact the surface of board 104 at a single point located along a horizontal line on the surface of board 104. In Fig. 2, this horizontal line is the minor axis of elliptical area 201.

When both horizontal and vertical tolerances are considered at the same time, the entire elliptical area 201 results. Area 201 represents an area of high probability of contact between a pin contact region of a mating connector and the surface of printed circuit board 200.

The length of the major axis of elliptical area 201 is the sum of all vertical tolerances affecting the relative vertical positions of a pin contact region and the board surface. The length of the minor axis of elliptical area 201 is the sum of all horizontal tolerances affecting the relative horizontal positions of a pin contact region and a board surface.

In the illustrated embodiment shown in Fig. 2, elliptical area 201 is oriented so that the major axis is substantially perpendicular with the edge of printed circuit board 200. This orientation results primarily from the vertical wiping action that occurs during contact between the pin contact regions of a mating connector and the surface of board 200.

If the wiping action of the pin contact regions were horizontal, i.e., parallel with the edge of printed circuit board 200, elliptical area 201 would be oriented so that the minor axis is substantially perpendicular to the edge of printed circuit 200.

If there were no wiping action between the pin contact regions and the surface of board 200, area 201 may even assume a circular shape.

Area 201 is calculated by consideration of mechanical dimensional tolerances including tolerances associated with contact pin length and width as well as tolerances associated with printed circuit board 200 dimensions and horizontal and vertical position within a mating connector. The border (dashed line) of elliptical area 201 represents a contour of equal probability of contact between a contact pin and the surface of printed circuit board 200. Area 201 represents the area of high probability of contact while the area outside of area 201 represents the area of low probability of contact. A particular elliptical area 201 is chosen according to the requirements of the particular printed circuit board application. If a small elliptical area 201 is chosen, electrical contact pads 202 can be closely spaced but at the cost of reducing the probability of electrical contact. If a large area 201 is chosen, the probability of electrical contact will increase but electrical contact pads 202 will be required to be spaced further apart.

A two row pad pattern is shown in solid lines in Fig. 2. Row 203 is located nearest the edge of printed circuit board 200 and row 204 is located farthest from the edge. Each individual contact pad 202 and 206 encloses a single elliptical area 201. The edges of pads 202 and 206 are straight lines in order to facilitate the layout of printed circuit board 200.

Pads 206 of row 204 are slightly interleaved with and offset with respect to pads 202 of row 203.

Offsetting and interleaving the pad patterns in this manner will allow row 204 to be located closer to the edge of printed circuit board 200 thereby reducing the area required for electrical connections while preserving the remaining interior area of printed circuit board 200 for the mounting of electrical components.

For the purposes of this specification, interleaving signifies an overlap between the vertical axes (i.e., perpendicular to the edge of the printed circuit board 200) of the elliptical areas of adjacent rows of contacts. This interleaving results in the combined width of the two adjacent rows being less than double the length of the vertical axis of area 201.

A third row 207 of electrical contact pads 208 can be added as shown by dashed lines in Fig. 2. In order to accommodate row 207, pads 206 must be modified to the diamond-shape shown in dashed lines. In a three row pad pattern each individual pad (202, 206, 208) contains an elliptical area 201 of high probability of contact.

The pads 208 of third row 207 are slightly interleaved and offset with respect to pads 206 of row 204. Once again, this allows third row 207 to be located closer to the edge of printed circuit board 200 thereby preserving the remaining interior area of printed circuit board 200 for the mounting of electrical components.

Any number of rows of electrical contact pads can be added in the same manner as the addition of row 207 herein described. The favourable overall effect of this new pad pattern is to reduce the printed circuit board area required for electrical connection while maintaining a high probability of making contact between contact pins and contact pads.

Referring to Fig. 3, a ZIF connector 300 mounted to mother board 301, is shown in cross-section and is similar to ZIF connector 102 shown in Fig. 1. In Fig. 3, the printed circuit board unit is removed from connector 300 and short contact pin 302 and long contact pin 303 are shown opposite each other. ZIF connector 300 is shown in the actuated position as linear cams 304 urge housing 305 away from mother board 301. Inclined surfaces 306 and 307, contained within housing 305, force short contact pin 302 and long contact pin 303, respectively, toward the centre line 308 of connector 300. Centre line 308 is substantially co-planar with the board insertion path described during the discussion of Fig. 1.

In Fig. 3A, contact regions 309 and 310 of contact pins 302 and 303, respectively, have passed through centre line 308 but as shown in Fig. 3A, they do not touch one another. Contact region 309 of short pin 302 is under contact region 310 of long contact pin 303.

Here it should be noted that not all of the contact regions of all of the opposed contact pin pairs of every connector must pass through centre line 308. The mechanical tolerances mentioned earlier may accumulate such that none or only some of the contact regions pass through centre line 308 in any one given connector of a production lot. However, in another given connector, mechanical tolerances may accumulate such that all contact regions of all opposed contact pin pairs pass through centre line 308. The offset pin configuration herein described and claimed will guarantee that no opposed pins will touch and short circuit in any connection of the production lot.

Contact pins 302' and 303' show the positions of pins 302 and 303, respectively, when they are in the self-biased, retracted position thereby clearing centre line 308 allowing a printed circuit board unit to enter connector 300. Pins 302 and 303 assume the retracted positions of 302' and 303' when linear cam 304 is moved thereby allowing housing 305 to move closer to mother board 301.

Inclined surfaces 311 and 312 are contained within housing 305 and serve to move the set of contact pins adjacent pins 302 and 303. This set of adjacent pins is not shown in Fig. 3A in order to make the figure more clear.

Fig. 3B is a view taken through section A—A of Fig. 3A. In Fig. 3B, long pin 313 is shown adjacent short pin 302. Inclined surface 311 is attached to housing 305 and serves to move long pin 313 when housing 305 is moved by linear cam 304. Long pin 313 has a contact region 314 that lies substantially in a first horizontal plane with contact region 310 of long pin 308 shown in Fig. 3A. The contact regions of all remaining long contact pins in ZIF connector 300 also substantially lie in this first horizontal plane.

Adjacent long pin 313 in Fig. 3B is short pin 315 with cooperating inclined surface 316 attached to housing 305. Contact region 317 of short pin 315 substantially lies in a second horizontal plane with contact region 309 of short pin 302. The contact regions of all remaining short pins in ZIF connector 300 also substantially lie in this second horizontal plane.

The preferred configuration of alternating long pins and short pins within a single row is shown in Fig. 3B and also in Fig. 1. In Fig. 3, contact regions are shown to lie in only two horizontal planes because the connector illustrated in Fig. 3 is disposed to contact and wipe a two row pad pattern (e.g., rows 203 and 204 of Fig. 2). In order to contact and wipe a three row pad pattern (e.g., rows 203, 204, and 207 of Fig. 2) the contact regions of the contact pins would lie substantially in three different horizontal planes and the contact pins would be of three different lengths. This is illustrated in Fig. 4.

In general, the contact regions of the contact pins will substantially lie in a number of horizontal planes equal to the number of contact pad rows on the corresponding mating printed circuit board. Also, due to the alternating pin lengths hereinbefore described, the contact regions of the pins will be distributed among these horizontal planes in substantially equal proportion.

Fig. 4 shows a ZIF connector 400 in partial cross section with a corresponding printed circuit board 401. ZIF connector 400 includes an actuator mechanism comprising the following elements:

handle 402, linear cam 403 with cam lobes 404, cam followers 405, and housing 406.

The components of this actuator mechanism cooperate in the same manner as the actuator mechanism of Fig. 1 to move housing 406 upward as handle 402 pivots counterclockwise. Once again, the illustration of this particular actuator mechanism should not be construed to delimit the invention in any manner.

Housing 406 contains inclined surfaces 407, 408 and 409 that cooperate with short pins 410, mid-length pins 411, and long pins 412, respectively. As housing 406 moves upward, in response to the counterclockwise pivotting of handle 402, inclined surfaces 407, 408, and 409 move pins 410, 411 and 412, respectively, toward printed circuit board 401 when printed circuit board 401 is inserted into ZIF connector 400.

Long pins 412 are disposed to contact and wipe electrical contact pads in row 413 located along the edge of printed circuit board 401. Mid length pins 411 are disposed to contact and wipe electrical contact pads in row 414 located along the edge of printed circuit board 401. Short pins 410 are disposed to contact and wipe electrical contact pads in row 415 located along the edge of printed circuit board 401.

Once again, the contact regions of the contact pins pass through the planar board insertion path when connector 400 is actuated in the absence of printed circuit board 401 within connector 400. In order to avoid contact between opposing pins, a mid length pin is located opposite a short pin and a long pin so that the contact region associated with the mid length pin will pass over the top of the contact region associated with the opposing short pin, and will pass under the contact region associated with the opposing long pin. In this manner, the contact regions of opposing pins will not touch and short circuit when ZIF connector 400 is actuated in the absence of printed circuit board 401 within connector 400.

This scheme of opposing contacts can be expanded to encompass a ZIF connector capable of contacting a printed circuit board with any number of rows of contact pads disposed along an edge thereof. Short circuiting of opposing contact pins is precluded by ensuring that each contact pin in the connector is never opposite a contact pin of equal length having a contact region in the same horizontal plane.

It will be understood that the preferred embodiments herein presented are for illustrative purposes, and, as such, do not place limitations on the invention. Those skilled in the art will understand that changes in the form and detail of the preferred embodiments recited may be made without departing from the scope of the appended claims.

## Claims

1. A circuit board adapted to mate with a zero insertion force type electrical connector (102) having two rows of connector contact pins (108, 110) on each side thereof, the circuit board having, for each connector contact pin to which electrical connection is required to be made, a corresponding contact pad (107), the contact pads forming, in general, two staggered rows on each side of the edge of the circuit board, the contact pads each having a narrowing aspect facing adjacent contact pads such that each contact pad encloses an elliptical area (201) of high probability of pin contact and such that the contact pads of the rows on each side of the circuit board partially nest between the contact pads of the other row, while remaining electrically insulated from such pads and from each other.

2. A board as claimed in Claim 1, wherein the major axis of the elliptical area is perpendicular to the insertion edge of the board.

3. A board as claimed in Claim 1 or Claim 2, wherein the axes of the elliptical area are determined by the summation of the manufacturing tolerances in the respective directions for both the board and the connector.

4. A board as claimed in any preceding claim in which the contact pad row nearest the edge of the board on one side thereof is laterally aligned with the contact pad row on the other side of the board next remote from the edge of the board.

5. A zero insertion force type electrical connector specifically adapted to receive an electrical circuit board (104) as claimed in claim 4 comprising a housing (117) of electrically insulating material having a base and two side walls together defining an elongated opening (122) opposite the base of the housing for receiving therein the insertion edge of the electrical circuit board and actuator displaceable contact pins mounted in the housing, forming, in the potential contact area, two rows of contact regions on each side of the housing, adapted to overlie the contact pads rows on the board so that, in general, on one side of the board, a long pin lies between a pair of short pins, and, where there is opposition, a long pin opposes a short pin, the pins being arranged, within mechanical tolerances and in the absence of the board and with the actuator operative, to cross the medial plane parallel to the side walls but only so far that each the contact region is precluded from touching any other contact region when the contact regions are moved through the medial plane by the actuator.

## Patentansprüche

1. Leiterplatte, welche für ein Zusammenpassen mit einem elektrischen Nulleinsetzkraft-Steckverbinder (102), welcher zwei Reihen von Steckerkontaktstiften (108, 110) auf jeder seiner Seiten aufweist, eingerichtet ist, wobei die Leiterplatte für jeden Steckerkontaktstift, zu welchem eine elektrische Verbindung herzustellen ist, eine entsprechende Kontaktanschlußfläche (107) aufweist, wobei die Kontaktanschlußflächen im allgemeinen zwei versetzte Reihen auf jeder Seite des Randes der Leiterplatte bilden, jede der Kontaktanschlußflächen ein sich verjüngendes Erscheinungsbild zugekehrt benachbarten Kontaktanschlußflächen aufweist, so daß jede Kontaktanschlußfläche einen elliptischen Bereich (201) hoher Stiftkontaktwahrscheinlichkeit umschließt, und so, daß die Kontaktanschlußflächen der Reihen auf jeder Seite der Leiterplatte teilweise zwischen die Kontaktanschlußflächen der anderen Reihe gepackt sind und dabei von solchen Anschlußflächen und voneinander elektrisch isoliert bleiben.

2. Leiterplatte nach Anspruch 1, bei welcher die große Achse des elliptischen Bereichs senkrecht zum Einsetzrand der Leiterplatte ist.

3. Leiterplatte nach Anspruch 1 oder 2, bei welcher die Achsen des elliptischen Bereichs durch die Summation der Herstellungstoleranzen in den betreffenden Richtungen für sowohl die Leiterplatte als auch den Steckverbinder bestimmt sind.

4. Leiterplatte nach irgendeinem vorstehenden Anspruch, bei welcher die dem Rand der Leiterplatte am nächsten liegende Kontaktanschlußflächenreihe auf der einen Seite derselben seitlich ausgerichtet auf die vom Rand der Leiterplatte nächstentfernte Kontaktanschlußflächenreihe auf der anderen Seite der Leiterplatte ist.

5. Elektrischer Nulleinsetzkraft-Steckverbinder, welcher speziell auf die Aufnahme einer elektrischen Leiterplatte (104) nach Anspruch 4 eingerichtet ist, mit einem Gehäuse (117) aus elektrisch isolierendem Material, welches eine Basis und zwei Seitenwände aufweist, die zusammen eine langgestreckte Öffnung (122) gegenüber der Basis des Gehäuses zur Aufnahme des Einsetzrandes der elektrischen Leiterplatte definieren, und in dem Gehäuse angebrachten stellerversetzbaren Kontaktstiften, welche im potentiellen Kontaktgebiet zwei Reihen von Kontaktbereichen auf jeder Seite des Gehäuses bilden, die so eingerichtet sind, daß sie über den Kontaktanschlußflächenreihen auf der Leiterplatte liegen, so daß im allgemeinen auf der einen Seite der Leiterplatte ein langer Stift zwischen einem Paar kurzer Stifte liegt und, wo eine Gegenüberstellung vorhanden ist, ein langer Stift einem kurzen Stift gegenübersteht, wobei die Stifte innerhalb mechanischer Toleranzen und bei Nichtvorhandensein der Leiterplatte und bei in Tätigkeit befindlichem Steller so eingerichtet sind, daß sie die zu den Seitenwänden parallele Mittelebene überqueren, aber nur so weit, daß für jeden der Kontaktbereiche ausgeschlossen ist, daß er irgendeinen anderen Kontaktbereich berührt, wenn durch den Steller die Kontaktbereiche durch die Mittelebene bewegt werden.

## Revendications

1. Carte de circuits destinée à être enfichée dans un connecteur électrique (102) du type à force d'insertion nulle comprenant deux rangées de broches de contact de connecteurs (108, 110) de chaque côté, la carte des circuits comportant, pour chaque broche de contact de connecteur avec laquelle une connexion électrique doit être établie, une surface de contact correspondante (107), les surfaces de contact formant, en général, deux rangées étagées de chaque côté du bord de la carte de circuits, les surfaces de contact ayant chacune un aspect se rétrécissant faisant face aux surfaces de contact voisines de manière que chaque surface de contact englobe une surface elliptique (201) de haute probabilité de contact de broche et de manière que les surfaces de contact des rangées de chaque côté de la carte de circuits soient logées partiellement entre les surfaces de contact de l'autre rangée, tout en restant électriquement isolées de ces surfaces de contact ainsi qu'entre elles.

2. Carte selon la revendication 1, dans laquelle le grand axe de la surface elliptique est perpendiculaire au bord d'insertion de la carte.

3. Carte selon la revendication 1 ou la revendication 2, dans laquelle les axes de la surface elliptique sont déterminés par l'addition de tolérances de fabrication dans les directions respectives, à la fois de la carte et du connecteur.

4. Carte selon l'une quelconque des revendications précédentes, dans laquelle la rangée de surfaces de contact la plus proche du bord de la carte sur l'un de ses côtés est alignée latéralement avec la rangée de surfaces de contact sur l'autre côté de la carte le plus éloigné du bord de la carte.

5. Connecteur électrique du type à force d'insertion nulle adapté spécifiquement pour recevoir une carte de circuits électriques (104) telle que revendiquée dans la revendication 4, comportant un boîtier (117) de matière isolante de l'électricité avec une base et deux parois latérales définissant ensemble une ouverture allongée (122) à l'opposé de la base du boîtier pour y recevoir le bord d'insertion de la carte de circuits électriques et des broches de contact pouvant être déplacées par un actionneur, montées dans le boîtier, formant dans la région de contact potentiel, deux rangées de régions de contact sur chaque côté du boîtier, agencé pour se trouver au-dessus des rangées de surfaces de contact de la carte de manière que d'une façon générale, sur un côté de la carte, une broche longue se situe entre deux broches courtes et que, lorsqu'elles sont en opposition, une broche longue se trouve en face d'une broche courte, les broches étant disposées dans des tolérances mécaniques et en l'absence de la carte alors que l'actionneur est actionné, pour croiser le plan médian parallèle aux parois latérales mais seulement d'une distance telle que chaque région de contact ne puisse toucher une autre région de contact quand ces régions de contact sont déplacées à travers le plan médian par l'actionneur.

*FIG. 2*

*FIG. 1*

A

308
310
303
303'
305
307
312
300
304

309
302
311
302'
306
305
304

301

_FIG. 3A_

A

305
314
311
317
309
316
306
315
313
302

301

_FIG 3B_

401
413
414
415
402
406
412
409
410
408
407
411
400
405 404 403

_FIG. 4_